# EUROPEAN PATENT APPLICATION

(11) **EP 1 912 486 A1**
(43) Date of publication of application: **16.04.2008**
(21) Application number: 06122199.0
(22) Date of filing: 12.10.2006
(51) Int. Cl.: H05K 7/20

(54) **Device for fixing a fan to a surface**

(71) Applicant: Thomson Licensing, 92100 Boulogne-Billancourt (FR)
(72) Inventor: Knight, Simon, Near Porth RCT CF39 8UA (GB)
(74) Representative: Berthier, Karine

(57) **Abstract**

The present invention concerns a device (1) for mounting a fan (2) on a surface (3). It comprises squeezing means (15) for fastening the fan, isolating means (13) for lessening any vibration of the fan on the surface, and holding means (14) for gripping the device to the surface.

## Description

The present invention relates to a device for fixing a fan to a surface.

An electronic device usually comprises at least one fan for cooling some electronic components. The fan is fixed to a board of the electronic device in the front of the element to be cooled. In the prior art the fan is fixed to the board with rivets or screws. Some of them are made of rubber in order to isolate the board from vibrations coming from the fan. Richco manufactures such rivets referred as 'isolator rivet for fan mount'. This requires four rivets per fan. The assembly and disassembly of rivets and screws is time consuming. Some screws may be lost or broken. And usually they are not universal: a fan requires a rivet or a screw adapted to its shape and its size. Moreover such rivers require hand cutting.

The present invention concerns a fan mount for fixing a fan to a surface. To this end, the invention relates to a device for mounting a fan on a surface. It comprises squeezing means for fastening the fan, isolating means for lessening any vibration of the fan on the surface, and holding means for gripping the device to the surface.
No tools are necessary to fix the fan mount to the surface. The fastening is made easily. It does not require much time to attach and detach the device to the surface, and the fan to the device. It speeds up the assembly and gives the option to have this fitted by the fan supplier prior to shipment.
The fan and the fan mount may be easily put in another different place of the board; or in the electronic device.

According to an embodiment of the invention, the squeezing means comprises a surrounding strip for fitting around the fan. The fan is easily fastened to the fan mount.

According to an embodiment of the invention, the device comprises a receptacle for leaning the fan on the device. The receptacle permits to adjust the positioning of the fan on the fan mount.

According to an embodiment of the invention, the isolating means comprises four pillars. They absorb the vibrations of the fan.

According to an embodiment of the invention, the holding means comprises four feet at the extremity of each pillar. The feet enable the fastening of the fan mount to the surface: it only requires putting the feet on the other side of the surface.

According to an embodiment of the invention, the device comprises pulling means for stretching the surrounding strip in order to set the fan inside. This facilitates the putting of the fan into the device.

Preferably, the device is made of a single piece of rubber or elastomeric material. The fan mount is flexible enough to fit to various fan sizes and thickness.

The invention will be better understood and illustrated by means of the following embodiment and execution examples, in no way limitative, with reference to the appended figures on which:
- The figure 1 represents the fan mount according to the embodiment;
- The figure 2 represents the square fan mount fixed to the surface with the fan fixed to the fan mount;
- The figure 3 represents the fan mount, the surface and the fan;
- The figure 4 represents another view of the fan mount fixed to the surface with the fan fixed to the fan mount;
- The figure 5 is another view of the feet of the fan mount fixed to the surface; and
- The figure 6 represents the opening in the surface.

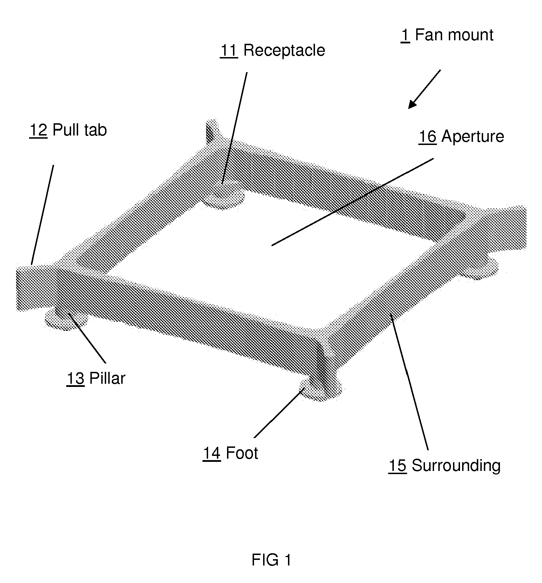

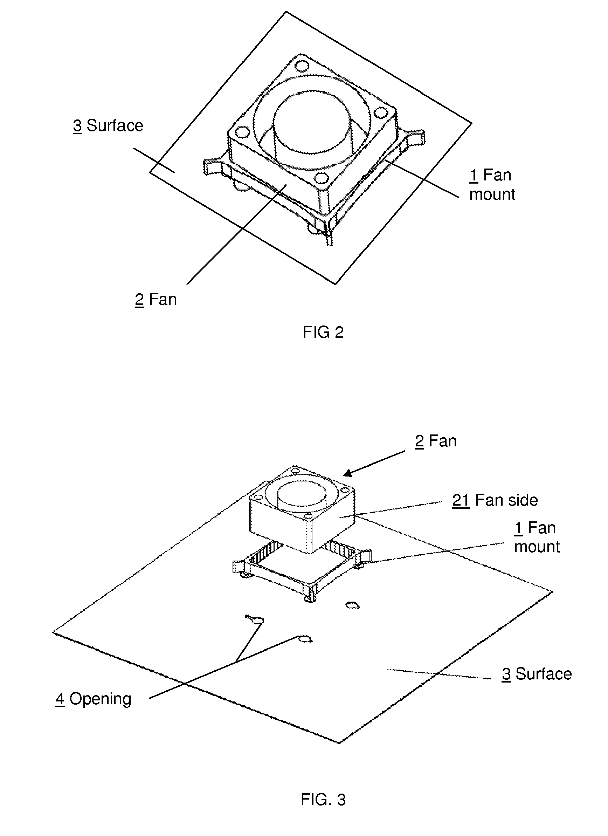

The figure 1 represents the fan mount 1 according to the embodiment. The fan mount is made of a single piece of rubber. It can be deformed and it resumes its original shape when the deforming force is removed. Alternatively, the fan mount could be made of elastomer having the same features as rubber.
The fan mount is intended to fasten the fan 2, surrounding the sides of the fan. The fan comprises a top, a bottom and the sides 21 that form its circumference, as indicated on figure 3. According to the embodiment, the shape of the fan is square, and the fan mount is intended to match to squared fans. Of course the fan mount could also be adapted to match to fan having another shape, such as a round shape.
The fan mount is also intended to be fixed to a surface 3. The surface comprises an internal side and an external side. The fan mount is set on the internal side of the surface. Of course the fan mount can be fixed to any kind of surface of a device requiring such a fan, such as a metal or plastic area of an electronic device

The fan mount comprises squeezing means for fastening a fan. According to the embodiment, a surrounding strip 15 surrounds the side of the fan. It squeezes the fan in order to fasten the fan. A receptacle 11 located inside the fan mount is intended to lean the bottom of the fan on the fan mount, when the fan is set inside the fan mount. The receptacle permits to adjust the positioning of the fan into the fan mount.
An aperture 16 matches the active flow area of the fan. It is intended to allow the fan to flow the air in the direction of the aperture.

The fan mount comprises pulling means for stretching the fan mount. Pull tabs 12 are set at around the surrounding strip 15, on the external side. They are intended to stretch the surrounding strip in order to fix it around the side of the fan. The fan mount may be relatively rigid. The pull tabs are then necessary to stretch the surrounding strip so that the fan can be set inside the surrounding strip. It facilitates the fixing of the fan mount around the fan.
To set the fan inside the surrounding strip, the surrounding strip is stretched with the pull tabs. When the fan is surrounded by the surrounding strip as represented in figure 2, the stretch is terminated and the surrounding strip resumes to its original shape, squeezing around the fan.
According to the embodiment, the fan mount comprises four pull tabs 12. They are located at opposite sides of the fan mount, at each corner of the square surrounding strip. Of course depending on the shape of the fan mount, more or less pull tabs could be necessary.

The fan mount comprises isolating means for isolating the surface from the fan. According to the embodiment, four pillars 13 are located below the surrounding strip. They isolate the surface from any vibration coming from the fan, thanks to the elastomeric properties of the material of which it is made. They are located at each corner of the square surrounding strip. In another words, they lessen any vibration of the fan on the surface.
Alternatively they are not located at each corner of the fan mount. They are located between the pull tabs. This permits to provide a different position to the fan with respect to the position of the pillars, and respectively the position of the openings on the surface.

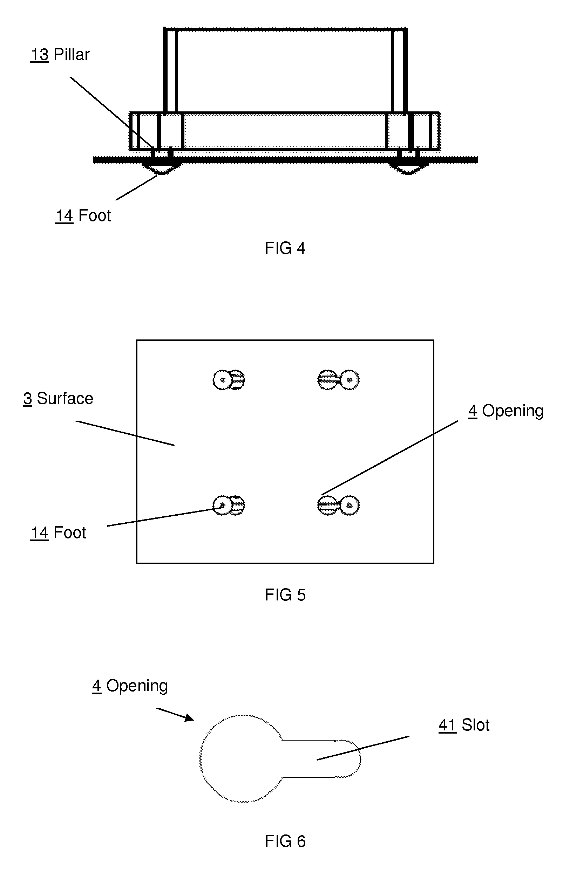

The fan mount comprises holding means for gripping the fan mount to the surface. According to the embodiment, four feet 14 are located at the extremity of each pillar 13. The feet are intended to fix the fan mount to the surface, as indicated in figure 2 and figure 4. The surface comprises openings 4 to receive each foot. The pillars comprise means for being deformed sufficiently for allowing the feet to grip to the surface. The pillars are deformed for allowing the fixing of the feet to the openings, and for allowing removing the pillars from the openings.
A foot comprises a disk that is placed on the external side of the surface through the opening, as indicated on figure 5.
Preferably, the opening has the form of a small circle for allowing the disk to be positioned on the other side of the surface. Each opening also comprises a slot 41 for fixing the feet, as indicated on figure 6.
The process for fixing the foot to the opening is as follows. The pillar is deformed to pass the foot across each opening. Then, when the foot is on the external side of the surface, the pillar resumes to its original shape, and goes into the slot.

Alternatively, the foot could comprise clipping means for clipping the fan mount to the surface.

The thickness of the surrounding strip is thin enough to allow the surrounding strip to be easily fixed over the fan.

According to the embodiment, the fan mount is made of a single piece of rubber. Of course it could be made of several pieces assembled together to provide the same functions as the one-block fan mount.

The flexibility of the rubber is homogeneous in the device of the embodiment. Alternatively the density could be inhomogeneous; in a fan mount having quite long pillars, the pillars might be more rigid than the rest of the fan mount.

## Claims

1. Device (1) for mounting a fan (2) on a surface (3), **characterized in that** it comprises:
- squeezing means (15) for fastening the fan;
- isolating means (13) for lessening any vibration of the fan on said surface; and
- holding means (14) for gripping said device to said surface.

2. Device according to the preceding claim, **characterized in that** said squeezing means (15) comprises a surrounding strip (15) for fitting around the fan.

3. Device according to the preceding claims, **characterized in that** it comprises a receptacle (11) for leaning said fan on the device.

4. Device according to the preceding claims, **characterized in that** said isolating means (13) comprises four pillars.

5. Device according to the preceding claims, **characterized in that** said holding means (14) comprises four feet at the extremity of each pillar (13).

6. Device according to the preceding claims, **characterized in that** it comprises pulling means (12) for stretching said surrounding strip in order to set the fan inside.

7. Device according to the preceding claims, **characterized in that** it is made of a single piece of rubber or elastomeric material.
